# EUROPEAN PATENT APPLICATION

(11) **EP 4 184 653 A1**
(43) Date of publication of application: **24.05.2023**
(21) Application number: 20951542.8
(22) Date of filing: 28.08.2020
(51) Int. Cl.: H01M 10/48, H01M 50/20, H02J 7/00

(54) **TEST METHOD AND MANUFACTURING METHOD**

(71) Applicant: Hirata Corporation, Kumamoto-shi, Kumamoto 861-0198 (JP)
(72) Inventor: KANEKO, Toshihiko, Kumamoto-shi, Kumamoto 861-0198 (JP)
(74) Representative: Müller-Boré & Partner Patentanwälte PartG mbB
(86) International application number: PCT/JP2020/032755
(87) International publication number: WO 2022/044292

(57) **Abstract**

A test method of a battery cell is provided. In a placement step, a device places, in a test tray, a magazine in which a plurality of battery cells are arrayed and stored. The test tray includes a pressurization mechanism configured to press, in an array direction, the plurality of battery cells stored in the magazine. In a pressurization step, the plurality of battery cells stored in the magazine in the array direction is pressed by the pressurization mechanism. In a transfer step, the test tray storing the magazine is transferred between a preparation area where the magazine is placed in the test tray in the placement step and a test area where a test of the plurality of battery cells is performed. In a test step, in the test area, a test concerning charge/discharge of the plurality of battery cells is performed in the test area in a state in which the plurality of battery cells are pressurized by the pressurization mechanism.

## Description

### TECHNICAL FIELD

The present invention relates to a test method and a manufacturing method of a battery cell.

### BACKGROUND ART

As a battery in an automobile, an electronic device, or the like, a battery body formed by arranging a plurality of batteries and connecting their electrodes is used in some applications. The battery cell is manufactured by a plurality of steps such as a step of assembling a battery cell and a step of conducting tests such as a charge/discharge test of the assembled battery cell (see PTLs 1 to 3). The battery cell after the assembly is sometimes transferred using a container capable of storing a plurality of battery cells from the viewpoint of battery cell protection and transfer efficiency. Also, a test of battery cell performance or the like is sometimes performed in a state in which a plurality of battery cells are arranged and pressurized. PTL 1 describes pressurizing battery cells at the time of transfer or a test of battery cells using a pressurization magazine configured to press the battery cells stored in a container. PTL 2 describes providing a mechanism configured to press a battery on the side of a charge/discharge stage where a charge/discharge test of a battery is performed and arranging a plurality of batteries on the charge/discharge stage.

### CITATION LIST

### PATENT LITERATURE

PTL 1: Japanese Patent Laid-Open No. 2018-106930
PTL 2: Japanese Patent No. 6644230
PTL 3: Japanese Patent Laid-Open No. 2013-178903

### SUMMARY OF INVENTION

### TECHNICAL PROBLEM

In steps other than tests such as the charge/discharge test of battery cells, the battery cells need not be pressurized. In PTL 1, however, since the mechanism for pressurizing battery cells is provided on the magazine for transfer, the magazine provided with the mechanism is used even in a step that does not need pressurization of battery cells. Hence, if many magazines with the unnecessary mechanism are used for transfer between steps including steps other than tests, the man-hour and cost required to manufacture the magazines increase. In PTL 2, after batteries are carried into the charge/discharge stage one by one, and the plurality of batteries are arranged, the batteries are pressurized. After the battery pressurization state is started, a test is conducted. Then, after completion of the test, the pressurization of the batteries is canceled, and the batteries need to be carried out one by one from the charge/discharge stage. For this reason, the test efficiency may lower.

The present invention provides a technique of suppressing lowering of a test efficiency while simplifying the structure of a transfer magazine for a battery cell.

### SOLUTION TO PROBLEM

According to the present invention, there is provided a test method of a battery cell, comprising:
a placement step of a device placing, in a test tray, a magazine in which a plurality of battery cells are arrayed and stored, the test tray including a pressurization mechanism configured to press, in an array direction, the plurality of battery cells stored in the magazine;
a pressurization step of pressing the plurality of battery cells stored in the magazine in the array direction by the pressurization mechanism;
a transfer step of transferring the test tray storing the magazine between a preparation area where the magazine is placed in the test tray in the placement step and a test area where a test of the plurality of battery cells is performed; and
a test step of performing, in the test area, a test concerning charge/discharge of the plurality of battery cells in a state in which the plurality of battery cells are pressurized by the pressurization mechanism.

### ADVANTAGEOUS EFFECTS OF INVENTION

According to the present invention, a technique of suppressing lowering of a test efficiency while simplifying the structure of a transfer magazine for a battery cell is provided.

### BRIEF DESCRIPTION OF DRAWINGS

Fig. 1 is a plan view for explaining the outline of a test system according to the first embodiment;
Fig. 2 is a front view of the test system shown in Fig. 1;
Fig. 3 is a perspective view showing the outline of a transfer device;
Fig. 4A is a plan view for explaining an example of the configuration of a work portion;
Fig. 4B is a front view for explaining an example of the configuration of the work portion;
Fig. 5 is a block diagram showing an example of the configuration of the hardware of the test system;
Fig. 6 is a perspective view showing the outline of a magazine and a test tray;
Fig. 7A is a plan view showing a state of the test tray;
Fig. 7B is a plan view showing a state of the test tray;
Fig. 7C is a plan view showing a state of the test tray;
Fig. 8 is a flowchart showing the outline of a part of the manufacturing step of a battery cell;
Fig. 9 is a flowchart showing a detailed example of a battery cell formation step;
Fig. 10 is a flowchart showing an example of control of the test system;
Fig. 11A is a plan view for explaining the configuration of a test tray according to the second embodiment;
Fig. 11B is a plan view for explaining the configuration of the test tray according to the second embodiment;
Fig. 12A is a view for explaining a regulation operation by the pressurization movement regulation portion of the test tray according to the second embodiment;
Fig. 12B is a view for explaining a regulation operation by the pressurization movement regulation portion of the test tray according to the second embodiment; and
Fig. 13 is a plan view for explaining the configuration of a test tray according to the third embodiment.

### DESCRIPTION OF EMBODIMENTS

Hereinafter, embodiments will be described in detail with reference to the attached drawings. Note, the following embodiments are not intended to limit the scope of the claimed invention. Multiple features are described in the embodiments, but limitation is not made an invention that requires all such features, and at least two feature in multiple such features explained in the embodiment may be combined as appropriate. Furthermore, the same reference numerals are given to the same or similar configurations, and redundant description thereof is omitted. Note that in the drawings, the X and Y directions are defined as horizontal directions, and the Z direction is defined as the vertical direction. Also, for the sake of visibility in the drawings, some reference numerals are sometimes omitted.

### <First Embodiment>

### <Outline of Test System>

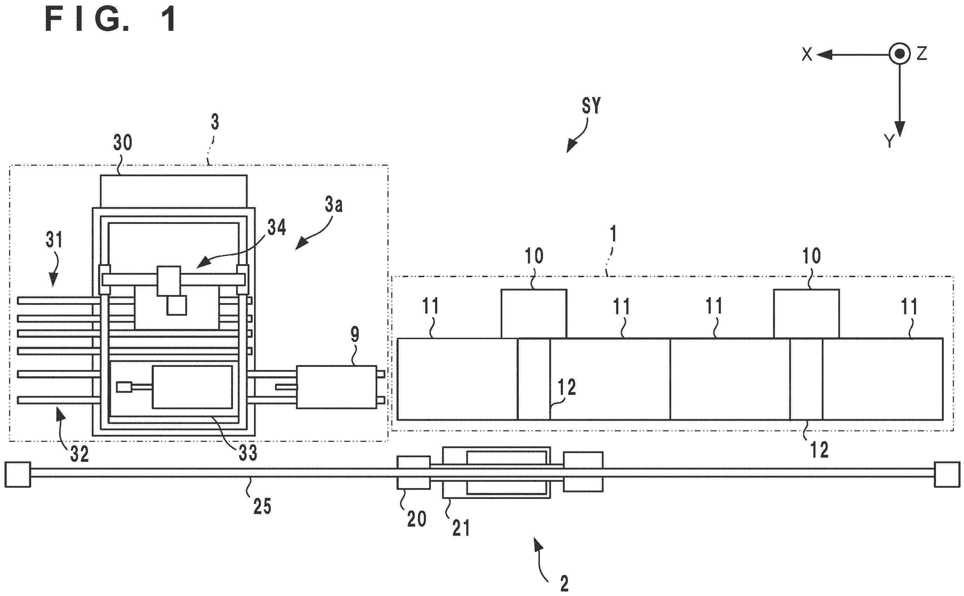

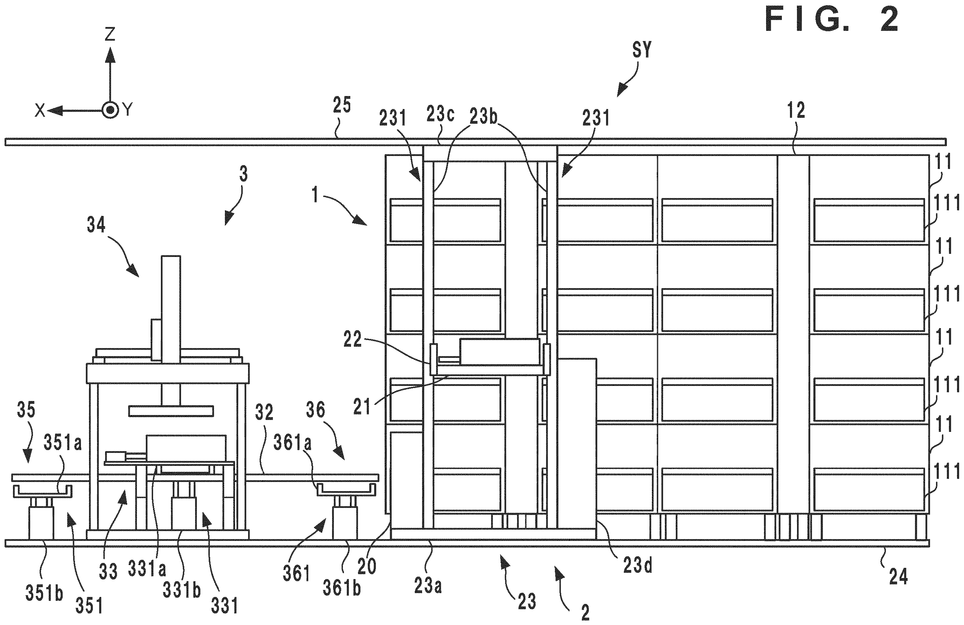

Fig. 1 is a plan view for explaining the outline of a test system SY according to the first embodiment. Fig. 2 is a front view of the test system SY shown in Fig. 1. The test system SY is a system configured to conduct a test of an assembled battery cell in manufacturing of a battery cell. The test system SY includes a test area 1, a transfer portion 2, and a preparation area 3.

The test area 1 is an area where a test is conducted for a plurality of battery cells 7 stored in a magazine 8 placed on a placement portion 91 of a test tray 9 to be described later. In this embodiment, a charge/discharge test of the battery cell 7 is performed in the test area 1. The test area 1 includes a test portion 11, an exhaust portion 12, and a test portion control device 10. In this embodiment, a plurality of test portions 11 are provided in the test area 1, and the test of the battery cell 7 is conducted in each test portion 11. A shutter 111 capable of being opened/closed is provided on the test portion 11 on the side of the transfer portion 2. The test tray 9 can be carried into the test portion 11 by opening the shutter 111. Note that in this embodiment, 4 rows × 4 columns = 16 test portions 11 are provided. However, the number and arrangement of test portions 11 can appropriately be set. More specifically, in this embodiment, the test portions 11 are formed as test portion groups each including a set of 4 rows × 2 columns = 8 test portions, and a total of two sets are arranged. The exhaust portion 12 is arranged between one test portion 11 of 4 rows × 1 columns, which form one test portion group, and the other test portion 11 and is connected to each test portion 11 to exhaust the interior of the test portion 11. The test portion control device 10 controls the test portion 11 and the exhaust portion 12. As an example, the test portion control device 10 controls opening/closing of the shutters 111, charge/discharge and test of the battery cell 7 at the time of a test, driving of an exhaust fan (not shown) provided in the exhaust portion 12, and the like.

In this embodiment, the test area 1 and the preparation area 3 of the test system SY are arranged on one side of the transfer portion 2, and the test tray 9 is transferred by the transfer portion 2 between the test area 1 and the preparation area 3. Also, one of the test area 1 and the preparation area 3 may be arranged on the other side of the transfer portion 2. Furthermore, a plurality of test areas 1 or preparation areas 3 may be arranged. The arrangement may appropriately be decided in accordance with the test efficiency.

The transfer portion 2 transfers the test tray 9 in which the magazine 8 is placed to the test area 1. In this embodiment, the transfer portion 2 is a so-called stacker crane, and transfers the test tray 9 in which the magazine 8 is placed in the preparation area 3 to the test portion 11 in the test area 1. The transfer portion 2 includes a holding portion 21, a lifting portion 22, and a traveling portion 23. A path guide portion configured to guide the movement of the transfer portion 2 is provided on the moving path of the transfer portion 2.

In the path guide portion, a traveling rail 24 with which the lower portion of the transfer portion 2 can engage is extended in the X direction serving as a traveling direction. Also, in the path guide portion, an upper rail 25 which is provided above the transfer portion 2 and with which the upper portion of the transfer portion 2 can engage is extended in the X direction serving as a traveling direction, like the traveling rail 24. The traveling rail 24 and the upper rail 25 each have a length capable of transferring the test tray 9 between the test portion 11 and the preparation area 3, which are arranged in the traveling direction.

The holding portion 21 holds the test tray 9. In this embodiment, the holding portion 21 is a plate-shaped member on which the test tray 9 is placed. Also, the holding portion 21 can include a fork moving mechanism configured to put the test tray 9 in and out of the test portion 11. For example, after the test tray 9 placed on the plate-shaped member of the holding portion 21 is transferred to the front of a predetermined test portion 11 in the test area 1, a moving body included in the fork moving mechanism is moved to the test portion, thereby carrying the test tray 9 into the test portion.

The lifting portion 22 guides the lifting movement of the holding portion 21 in the vertical direction (Z direction). The lifting portion 22 is supported to be movable along lifting rails 23b to be described later.

The traveling portion 23 includes a lifting support body including a traveling body 23a supported to be moveable along the traveling rail 24 extending in the X direction, and the lifting rails 23b configured to guide the movement of the lifting portion 22 in the lifting direction, and a moving mechanism portion 23d including a traveling moving mechanism configured to move the traveling body 23a, and a lifting moving mechanism configured to move the lifting portion 22. The traveling body 23a includes an engaging portion engaging with the traveling rail 24 and wheels (none are shown).

A lifting support body 231 is a support member supported on the upper portion of the traveling body 23a and extended upward with a predetermined length, and the lifting rail 23b that guides the lifting movement of the lifting portion 22 is extended. In this embodiment, the lifting support body 231 has a length larger than the height of the test portion 11. Also, the lifting rail 23b has a lifting-direction length capable of carrying the test tray 9 supported by the lifting portion 22 into the test portion 11 or carrying out the test tray 9 from the test portion 11.

Each of the fork moving mechanism, the lifting moving mechanism, and the traveling moving mechanism (none are shown) is configured to be able to stop at an arbitrary position in its moving direction, and transfer of the test tray 9 to a predetermined test portion 11 and extraction of the test tray 9 from a predetermined test portion 11 are possible. Note that as detailed configurations of these mechanisms, known techniques can be applied.

Also, the traveling portion 23 includes an upper support portion 23c that is engaged with the upper rail 25 and guided. The upper support portion 23c is movably supported by the upper rail 25, thereby preventing the lifting support body from swinging and allowing it to stably move.

In addition, the transfer portion 2 includes a transfer portion control device 20 that controls the operations of the holding portion 21, the lifting portion 22, and the traveling portion 23. Based on an instruction from a host computer 5 to be described later, the transfer portion control device 20 controls the holding portion 21, the lifting portion 22, and the traveling portion 23, and controls transfer of the test tray 9 to a predetermined test portion 11 and the preparation area 3.

The preparation area 3 is an area where a preparation for a test to be conducted in the test area 1 is made, and in this embodiment, the magazine 8 is transferred to the placement portion 91 of the test tray 9. The preparation area 3 is arranged along the traveling rail 24. In this embodiment, transfer of the magazine 8 is performed by a transfer device 3a to be described below in detail.

### <Transfer Device>

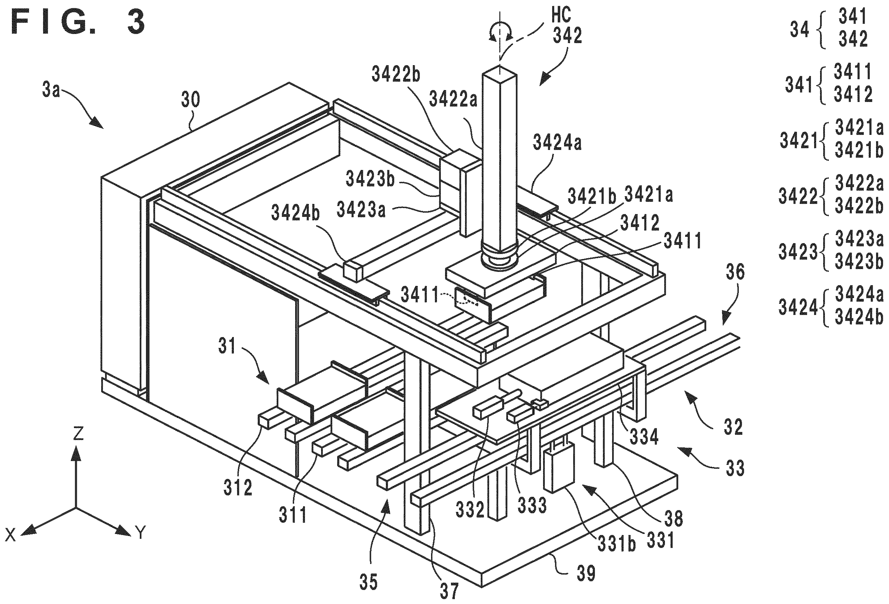

Fig. 3 is a perspective view showing the outline of the transfer device 3a. The transfer device 3a is provided in the preparation area 3, and transfers the magazine 8 to the placement portion 91 of the test tray 9. The transfer device 3a includes a magazine conveyance portion 31, a test tray conveyance portion 32, a work portion 33, and a transfer portion 34.

The magazine conveyance portion 31 conveys the magazine 8 from the outside of the range of the test system SY to the inside of the range of the test system SY Also, the magazine conveyance portion 31 conveys the magazine 8 from the inside of the range of the test system SY to the outside of the range of the test system SY Also, in this embodiment, the magazine conveyance portion 31 conveys the magazine 8 to the work portion 33. More specifically, the magazine conveyance portion 31 includes a carry-in conveyor 311 that carries the magazine 8 storing the battery cells 7 before the test into the work portion 33 provided in the preparation area 3 of the test system SY, and a carry-out conveyor 312 that carries out the magazine 8 storing the tested battery cells 7 from the work portion 33 provided in the preparation area 3 of the test system SY When the plurality of conveyors are provided, transfer of the magazine 8 is more efficiently performed. In this embodiment, two lanes of conveyors are provided.

The test tray conveyance portion 32 conveys the test tray 9 to the work portion 33. Also, the test tray conveyance portion 32 conveys the test tray 9 from the work portion 33. In this embodiment, the test tray conveyance portion 32 is a conveyor capable of conveying the test tray 9 in the X direction. In the transfer device 3a, a carry-in portion 35 and a carry-out portion 36 are provided on the conveyance path of the test tray conveyance portion 32 so as to sandwich the work portion 33. The carry-in portion 35 is a portion in which, when conveying the test tray 9 from the test area 1 to the preparation area 3, placement of the test tray 9 is performed by the transfer portion 2. The carry-out portion 36 is a portion in which, when conveying the test tray 9 from the preparation area 3 to the test area 1, extraction of the test tray 9 is performed by the transfer portion 2. The test tray conveyance portion 32 conveys the test tray 9 between the work portion 33, the carry-in portion 35, and the carry-out portion 36.

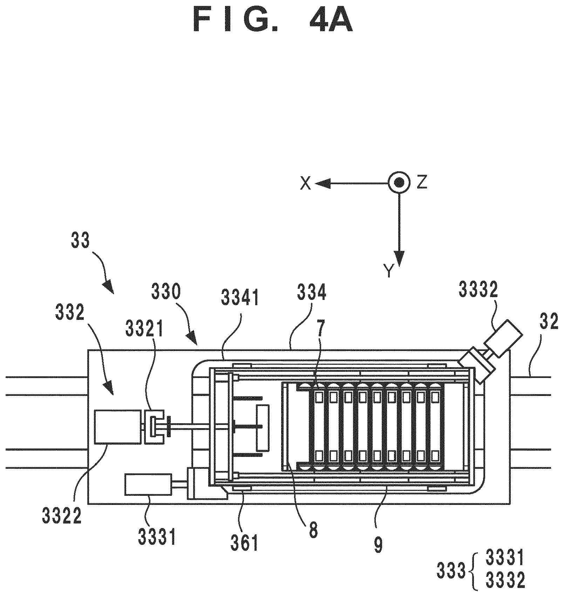

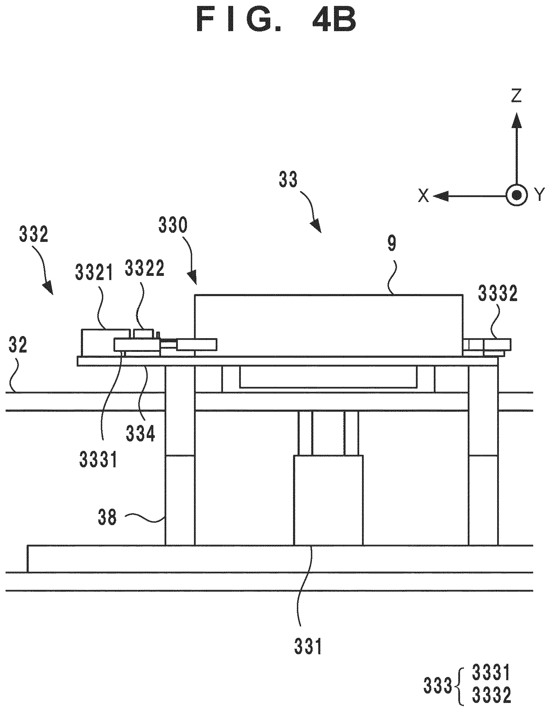

Figs. 4A and 4B will be referred to. Fig. 4A is a plan view for explaining an example of the configuration of the work portion 33, and Fig. 4B is a front view for explaining an example of the configuration of the work portion 33.

In the work portion 33, a transfer work of the magazine 8 to the test tray 9 or the operation of a pressurization mechanism 92 provided in the test tray 9 is performed. These works are done in a work area 330 formed above the test tray conveyance portion 32. The work portion 33 includes a lifting unit 331, an operation unit 332, a regulation unit 333, and a support member 334.

The lifting unit 331 lifts the test tray 9. Also, the lifting unit 331 supports the test tray 9. The lifting unit 331 includes a placement portion 331a on which the test tray 9 is placed, and a lifting portion 331b including a lifting mechanism configured to lift the placement portion. In this embodiment, the test tray 9 can be vertically moved between the conveyance path of the test tray conveyance portion 32 and the work area 330 above. To the lifting unit 331, a known technique such as an electric cylinder can be applied.

The operation unit 332 operates the pressurization mechanism 92 provided in the test tray 9. The operation unit 332 includes an engaging portion 3321 that engages with an operation member 9211 of the pressurization mechanism 92, and a driving portion 3322 that operably drives the engaging portion 3321. The operation of the operation unit 332 will be described later.

The regulation unit 333 performs positioning of the test tray 9 at a transfer position where the transfer work is performed. In this embodiment, the movement, at the transfer position, of the test tray 9 supported by the lifting unit 331 in the work area 330 is regulated by a regulation portion 3331 and a regulation portion 3332, and the test tray 9 is positioned to the transfer position. The regulation portions 3331 and 3332 are each formed by, for example, a support portion that supports the test tray 9, and a driving portion that drives the support portion. To the driving portion in this case, a known actuator such as an electric or air cylinder can be applied.

The support member 334 supports the operation unit 332 and the regulation unit 333. In this embodiment, the support member 334 provided above the test tray conveyance portion 32 is a plate-shaped member, and the work area 330 is formed on its upper surface. In addition, an opening 3341 larger than the outer size of the test tray 9 is formed in the support member 334, and the test tray 9 is moved by the lifting unit 331 from the test tray conveyance portion 32 to the work area 330 via the opening 3341.

The transfer portion 34 transfers the magazine 8 to the test tray 9 arranged in the work portion 33. Also, the transfer portion 34 transfers the magazine 8 from the test tray 9 arranged in the work portion 33. More specifically, the transfer portion 34 transfers the magazine 8 storing untested battery cells 7 from the carry-in conveyor 311 to the test tray 9 arranged in the work portion 33. Also, the transfer portion 34 transfers the magazine 8 storing tested battery cells 7 from the test tray 9 arranged in the work portion 33 to the carry-out conveyor 312.

The transfer portion 34 includes a holding unit 341 and a moving unit 342. The holding unit 341 holds the magazine 8. In this embodiment, the holding unit 341 includes holding members 3411 that hold the magazine 8, and a driving portion 3412 including a moving mechanism configured to move the holding members 3411 such that these can move close to or apart from each other. The holding member 3411 includes an engaging portion (not shown) that can be engaged/disengaged with/from a holding portion set on the magazine 8, and holds the magazine 8 or cancels the holding when the driving portion 3412 drives.

The moving unit 342 moves the holding unit 341. The moving unit 342 includes a rotation mechanism 3421 that rotates the holding unit 341 about a lifting shaft HC extending in a direction parallel to the lifting direction, a lifting mechanism 3422 that lifts the rotation mechanism 3421, an X-direction moving mechanism 3423 that moves the lifting mechanism 3422 in the X direction that is a first horizontal direction orthogonal to the lifting direction, and a Y-direction moving mechanism 3424 that moves the X-direction moving mechanism 3423 in the Y direction that is a second horizontal direction orthogonal to the lifting direction and the X direction.

The rotation mechanism 3421 includes a rotating body 3421a to which the holding unit 341 is fixed, and a rotation driving portion 3421b including a rotation moving mechanism that rotationally moves the rotating body 3421a about the lifting shaft HC of the lifting mechanism 3422. When the rotation driving portion 3421b drives, the rotating body 3421a rotates about the lifting shaft HC to make the holding unit 341 rotate about the lifting shaft HC. The lifting mechanism 3422 includes a lifting moving body 3422a to which the rotation mechanism 3421 is fixed, and a lifting driving portion 3422b that moves the lifting moving body 3422a in the lifting direction. When the lifting driving portion 3422b drives, the lifting moving body 3422a is lifted to make the holding unit 341 lift together with the rotation mechanism 3421. The X-direction moving mechanism 3423 includes an X-direction moving body 3423a to which the lifting mechanism 3422 is fixed, and a first horizontal driving portion 3423b that moves the X-direction moving body 3423a in the X direction. When the first horizontal driving portion 3423b drives, the X-direction moving body 3423a reciprocally moves in the X direction to make the holding unit 341 horizontally move in the X direction together with the lifting moving mechanism 3422. The Y-direction moving mechanism 3424 includes a Y-direction moving body 3423a provided with a guide portion which has a predetermined length and with which the X-direction moving mechanism 3423 engages to be movable in the X direction and formed in a predetermined length in the X direction, and a second horizontal driving portion 3424b that moves the Y-direction moving body 3424a in the Y direction. When the second horizontal driving portion 3424b drives, the Y-direction moving body 3424a reciprocally moves in the Y direction to make the holding unit 341 horizontally move in the Y direction together with the X-direction moving mechanism 3423. To these mechanisms, a mechanism such as a ball screw mechanism, a rack and pinion mechanism, or a belt transmission mechanism using a motor as a driving source can be applied.

The carry-in portion 35 is a place which is provided on the conveyance path of the test tray conveyance portion 32 and into which the test tray 9 is carried in by the transfer portion 2. In this embodiment, a lifting unit 351 is provided in the carry-in portion 35, and the lifting unit 351 is configured to receive the test tray 9 from the transfer portion 2 on the upper side of the test tray conveyance portion 32. The lifting unit 351 includes a placement portion 351a on which the test tray 9 is placed, and a lifting portion 351b including a lifting mechanism that lifts the placement portion 351a. This makes it possible to easily perform reception of the test tray 9 between the test tray conveyance portion 32 and a fork or the like provided in the holding portion 21 of the transfer portion 2.

The carry-out portion 36 is a place which is provided on the conveyance path of the test tray conveyance portion 32 and in which carry-out of the test tray 9 by the transfer portion 2 is waited for. In this embodiment, a lifting unit 361 is provided in the carry-out portion 36, and the lifting unit 361 is configured to transfer the test tray 9 to the transfer portion 2 on the upper side of the test tray conveyance portion 32. The lifting unit 361 includes a placement portion 361a on which the test tray 9 is placed, and a lifting portion 361b including a lifting mechanism that lifts the placement portion. This makes it possible to easily perform transfer of the test tray 9 between the test tray conveyance portion 32 and a fork or the like provided in the holding portion 21 of the transfer portion 2.

Also, the transfer device 3a includes a transfer support portion 37 that supports the transfer portion 34, and a work support portion 38 that supports the work portion 33. The transfer support portion 37 and the work support portion 38 are integrally supported by a base portion 39. Since this regulates the relative position between the work portion 33 and the transfer portion 34, transfer of the magazine 8 can more accurately be performed. Also, if the test tray conveyance portion 32 and the work portion 33 are aligned, the work area 330 can be set, and the transfer device 3a can easily be arranged with respect to the test tray conveyance portion 32.

### <Example of Hardware Configuration>

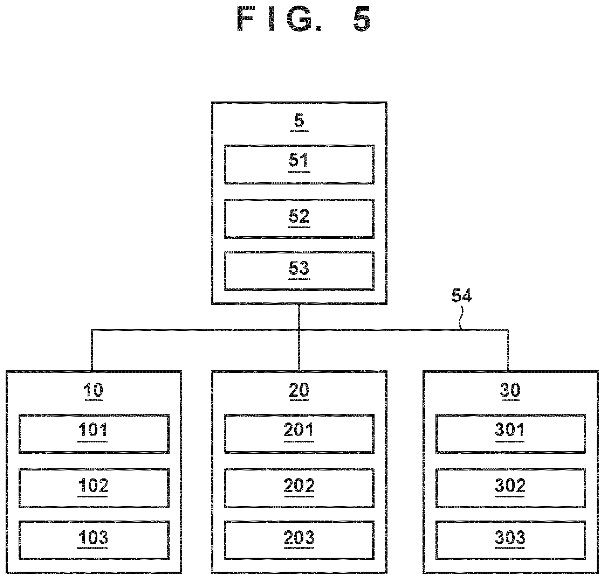

Fig. 5 is a block diagram showing an example of the configuration of the hardware of the test system SY The test system SY is comprehensively controlled by a host computer 5 that is a host device. For example, if the host computer 5 transmits control signals to the test portion control device 10, the transfer portion control device 20, and a preparation control device 30, the control devices 10, 20, and 30 control, based on the information received from the host computer 5, constituent elements included in control ranges controlled by the control devices 10, 20, and 30. Note that the host computer 5 may comprehensively control the whole manufacturing line of the battery cells 7 including not only the test system SY but also devices associated with a battery cell formation step that is an upstream step of a test.

The host computer 5 includes a processing portion 51, a storage portion 52, and an I/F portion 53. The processing portion 51 is a processor represented by a central processing unit (CPU) and comprehensively controls the constituent elements of the test system SY by executing programs stored in the storage portion 52. The storage portion 52 is a storage device (storage means) such as a read only memory (ROM), a random access memory (RAM), or ahard disk drive (HDD), and stores various kinds of information in addition to the programs to be executed by the processing portion 51. The I/F portion 53 (interface portion 53) is an interface that transmits/receives signals between the processing portion 51 and an external device. The I/F portion 53 can include, for example, an input/output (I/O) interface or a communication interface. In this embodiment, the I/F portion 53 is a communication device that includes a communication interface and performs communication with another device via a communication line 54, and the processing portion 51 transmits/receives information to/from the control devices 10, 20, and 30 of each test portion via the communication interface. Note that the whole or a part of the control device 5 (to be referred to as the host computer 5 hereinafter) of management may be formed by a programmable logic controller (PLC), an application specific integrated circuit (ASIC), or a field programmable gate array (FPGA).

The test portion control device 10 includes a processing portion 101, a storage portion 102, and an I/F portion 103. The transfer portion control device 20 includes a processing portion 201, a storage portion 202, and an I/F portion 203. The preparation control device 30 includes a processing portion 301, a storage portion 302, and an I/F portion 303. These can have the same configurations as the processing portion 51, the storage portion 52, and the I/F portion 53 of the host computer 5, respectively.

### <Magazine>

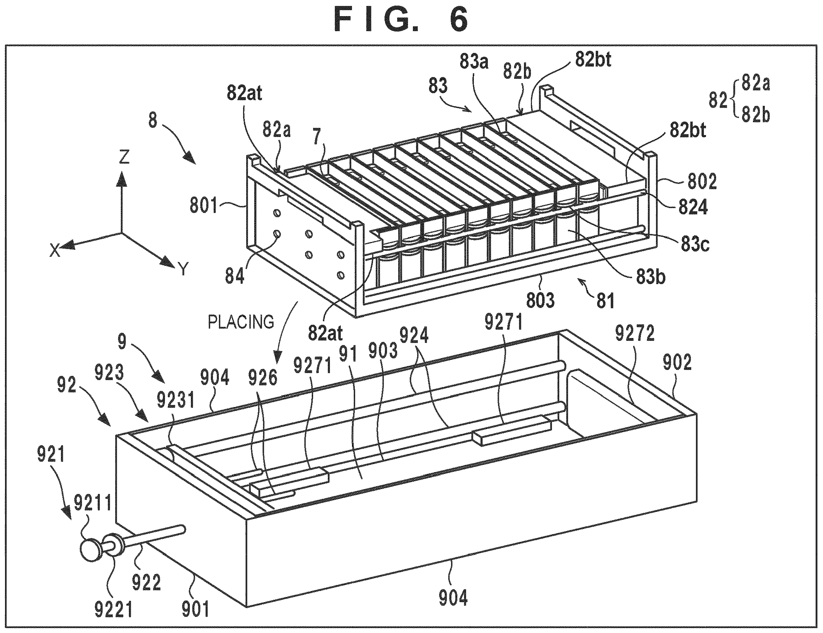

Fig. 6 is a perspective view showing the outline of the magazine 8 and the test tray 9.

The magazine 8 is a container that arrays and stores the plurality of battery cells 7. The magazine 8 includes a storage portion 81, a support member 82, and a plurality of partition members 83. By storing the plurality of battery cells 7 in the magazine 8, the battery cells 7 can efficiently be transferred in the manufacturing step of the battery cells 7.

The storage portion 81 is a portion in which the battery cells 7 are arrayed and stored, and includes a front wall 801 provided on one side of the storage portion 81 in the array direction, a rear wall 802 provided on the other side of the storage portion 81 in the array direction, a bottom wall 803 provided between the front wall 801 and the rear wall 802 and connected to the lower end portions of the front wall 801 and the rear wall 802, and a pair of support guide members 824 that are provided apart from each other above the bottom wall 803 and connect the front wall 801 and the rear wall 802. The pair of support guide members 824 are arranged apart from each other in the horizontal direction orthogonal to the array direction and connected to the side end portions of the front wall 801 and the rear wall 802 in the horizontal direction orthogonal to the array direction. The pair of support guide members 824 guide the movement of the partition members 83 in the array direction and movably support these. In this embodiment, the battery cell 7 has a flat shape thin in the thickness direction. When arraying the plurality of battery cells 7 in the thickness direction and storing these in the storage portion 81, the battery cells 7 are supported by the plurality of partition members 83 and stored in the storage portion 81. The pair of support guide members 824 guide the movement of the support member 82 in the array direction and movably support this. The thickness direction will sometimes be referred to as the array direction of the battery cells 7 hereinafter. Note that the thickness size of the battery cells 7 may change depending on the type, and the number of battery cells 7 storable in the storage portion 81 can appropriately be set in accordance with the thickness size.

The support member 82 is a member configured to support the battery cells 7 in the array direction, and is provided with one support member 82a arranged on one side of the array direction, and the other support member 82b arranged on the other side of the array direction. The support members 82a and 82b are configured to be movably supported by the pair of support guide members 824 from one side to the other side of the array direction or from the other side to one side of the array direction. Also, the support member 82a includes a pair of engaging portions 82at that engage with the pair of support guide members 824 and are supported to be movable in the array direction. The support member 82a is provided in the array direction between the front wall 801 and the partition members 83 of the battery cells 7 stored in the storage portion 81. A surface of the support member 82a on one side of the array direction is provided as a pressing surface that presses the battery cells 7, and a surface on the other side of the array direction is provided as a pressed surface pressed by a pressing portion 926 to be described later. The support member 82b includes a pair of engaging portions 82bt that engage with the pair of support guide members 824 and are supported to be movable in the array direction. The support member 82b is provided in the array direction between the rear wall 802 and the partition members 83 of the battery cells 7 stored in the storage portion 81. A surface of the support member 82b on one side of the array direction is provided as one abutting surface that abuts against the rear wall 802, and the other surface in the array direction is provided as the other abutting surface that abuts against the battery cell 7 (more specifically, the partition member 83 to be described later) moved by the pressurization mechanism 92 in a pressurization direction that is one side in the array direction. If the battery cell 7 moved by the pressurization mechanism 92 to one side in the array direction abuts against the other abutting surface of the support member 82b, the support member 82b is moved to one side in the array direction together with the battery cells 7.

When the one abutting surface of the support member 82b moved to the one side in the array direction abuts against the rear wall 802, the support member 82b is regulated from moving to the one side in the array direction. If the movement to the one side in the array direction is regulated, the position of the support member 82b with respect to the magazine 8 in the array direction is defined based on the rear wall 802 as a reference. If the other abutting surface of the support member 82b whose movement is regulated abuts against the battery cell 7, the battery cells 7 are regulated from moving the one side in the array direction, and the positions of the battery cells 7 in the magazine 8 in the array direction are defined based on the support member 82b as a reference. Also, if the battery cells 7 whose movement is regulated are further pressed and moved to the one side in the array direction by the pressurization operation of the pressurization mechanism 92, a pressure is applied to the battery cells 7. In this embodiment, the pressure is applied from the pressurization mechanism 92 to the battery cells 7 via the support member 82a.

The partition member 83 includes partition portions 83a provided between the plurality of battery cells 7 stored in the storage portion 81, and a support portion 83b that supports the battery cell 7. Also, the partition member 83 includes a pair of engaging portions 83c that engage with the pair of support guide members 824, respectively, and can move in the array direction. The plurality of partition members 83 are members configured to support and partition the battery cells 7 stored in the storage portion 81. The partition members 83 are provided to be slidable with respect to the storage portion 81 in the array direction of the battery cells 7.

In the front wall 801, a plurality of openings 84 are formed as holes extending through in the array direction. The openings 84 in the front wall 801 are openings configured to apply a force in the array direction from the outside of the magazine 8 to the support member 82a. The force in the array direction is applied to the support member 82a by the pressing portions 926 (to be described later) pressing the support member 82a through the openings 84. In the front wall 801, the plurality of openings 84 are formed at a predetermined interval such that an even pressure is applied from the pressing portions 926 to the support member 82a. In this embodiment, the number of openings 84 provided in the front wall 801 is six. However, one large opening 84 may be formed if its size is smaller than the outer size of the support member 82a. Alternatively, two or more openings 84 may be formed if the pressure applied from the pressing portions 926 to the support member 82a is evenly applied. Also, if the magazine placed in the test tray 9 is moved to the other side in the array direction, the front wall 801 abuts against an extraction position defining portion 9273 (to be described later) provided in the test tray 9 and is regulated from moving to the other side in the array direction. Also, when placed in the test tray 9, the bottom wall 803 is movable in the array direction and is regulated from moving in the horizontal direction orthogonal to the array direction by a plurality of widthwise direction defining portions 9271 to be described later.

### <Test Tray>

The test tray 9 is used for a charge/discharge test of the battery cells 7 and presses the battery cells 7 stored in the magazine 8. The test tray 9 includes a wall portion 90, the placement portion 91, and the pressurization mechanism 92.

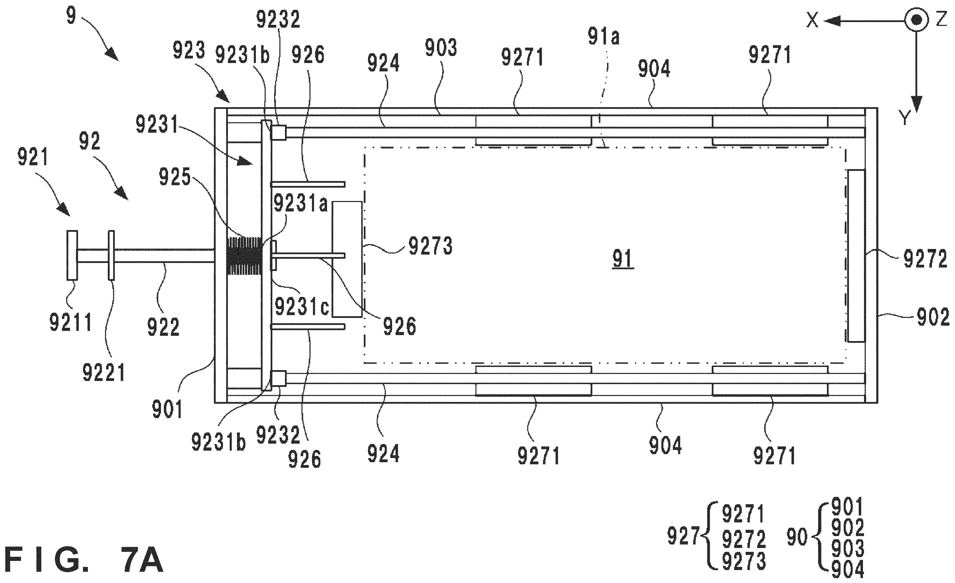

In the wall portion 90 (see Fig. 7A and the like), a front wall 901 is arranged on one side in the array direction, and a rear wall 902 is arranged on the other side in the array direction such that the placement portion 91 is sandwiched therebetween. Also, the wall portion 90 includes a bottom wall 903 that extends in the array direction and is connected to the lower portions of the front wall 901 and the rear wall 902. The wall portion 90 includes side walls 904 connected to the front wall 901 and the rear wall 902 and one side and the other side of the bottom wall 903 in the direction orthogonal to the array direction, and has a box shape open upward. Note that a configuration without the side walls 904 can also be employed.

The placement portion 91 (see Fig. 7A and the like) is a portion on which the magazine 8 is placed, and is provided on the bottom wall 903. In this embodiment, the magazine 8 in which the plurality of battery cells 7 are arrayed and stored is placed on the placement portion 91.

The pressurization mechanism 92 is a mechanism configured to press, in the array direction, the plurality of battery cells 7 stored in the magazine 8 placed on the placement portion 91. In this embodiment, the pressurization mechanism 92 moves the support member 82a from the side of the front wall 801 of the magazine 8, which is one side in the array direction, and presses the support member 82a to the one side in the array direction, thereby pressing the battery cells 7 stored in the magazine 8. The pressurization mechanism 92 includes an operation portion 921, a transmission member 922, a moving body 923, guide members 924, an application member 925 (see Fig. 7A and the like), and the pressing portions 926.

The operation portion 921 accepts an operation of the pressurization mechanism 92 from the outside and is provided outside the front wall 901. In this embodiment, the operation portion 921 accepts the operation of the pressurization mechanism 92 from the operation unit 332 of the work portion 33. When the operation unit 332 moves the operation portion 921 in the array direction, the moving body 923 is also moved in the array direction. The operation portion 921 includes the operation member 9211. The operation member 9211 is a portion that engages with the operation unit 332 when the pressurization mechanism 92 is operated by the operation unit 332. The operation member 9211 according to this embodiment is a circular flange member that is provided at one end portion of the transmission member 922 and extends from the transmission member 922 in a direction crossing the array direction.

The transmission member 922 is a rod-shaped member that connects the operation member 9211 and a plate-shaped member 9231 of the moving body 923. The transmission member 922 is provided through an opening formed in the front wall 901 and provided to be movable relative to the front wall 901.

An operation regulation portion 9221 is formed on the transmission member 922. The operation regulation portion 9221 regulates the movement of the transmission member 922 that is moved in a direction of applying a force by the application member 925 to be described later (the direction of separating the plate-shaped member 9231 from the front wall 901 based on the front wall 901 as a reference). In this embodiment, the operation regulation portion 9221 is a flange-shaped member provided on the transmission member 922 outside the front wall 901 and regulates the movement of the transmission member 922 by abutting against the outer surface of the front wall 901. The operation regulation portion 9221 makes the operation member 9211 and the front wall 901 apart at a predetermined interval and allows the operation unit 332 and the operation member 9211 to engage with each other.

The moving body 923 is a member that moves in the array direction of the plurality of battery cells 7. The moving body 923 moves when the operation portion 921 is operated from the outside, and the operation force is transmitted via the transmission member 922. The moving body 923 includes the plate-shaped member 9231 connected to the transmission member 922, and sliding bodies 9232 slidable with respect to the guide members 924. The plate-shaped member 9231 includes a connecting portion 9231a connected to the transmission member 922, sliding support portions 9231b on which the sliding bodies 9232 are provided, and a pressing support portion 9231c on which the pressing portions 926 are provided. The connecting portion 9231a is provided at the center of the plate-shaped member 9231. A total of four sliding bodies 9232 are provided, in which two each are provided at one end portion and the other end portion of the plate-shaped member 9231 in a direction orthogonal to the pressing direction and are configured at an interval in the vertical direction.

The guide members 924 guide the movement of the moving body 923 in the array direction. The guide members 924 are rod-shaped members extending in the array direction of the battery cells 7 and are provided such that the sliding bodies 9232 of the moving body 923 can slide along the guide members 924. A total of four guide members 924 are provided, in which two each are provided at one end portion and the other end portion of each of the front wall 901 and the rear wall 902 orthogonal to the array direction. Also, the two guide members 924 provided at one end portion and the two guide members 924 provided at the other end portion are provided in parallel at an interval in the vertical direction. In this embodiment, a member with a circular sectional shape is employed as the guide member 924.

The application member 925 applies a force in the array direction of the battery cells 7 to the moving body 923 moving body. The application member 925 may include an elastic member such as a spring. In this embodiment, the application member 925 is a compression spring and is provided between the front wall 901 and the plate-shaped member 9231 and between the transmission member 922 and the plate-shaped member 9231.

The pressing portions 926 (see Fig. 7A and the like) are provided while being connected to the plate-shaped member 9231 of the moving body 923 and press the support member 82a that is the pressed portion of the magazine 8. The pressing portions 926 are provided on the pressing support portion 9231c of the plate-shaped member 9231 so as to match positions corresponding to the positions of the openings 84 formed in the front wall 801 of the magazine 8 placed on the placement portion 91. The pressing portion 926 is a rod-shaped member having a predetermined length and extending from the plate-shaped member 9231 in the array direction. If the plate-shaped member 9231 moves to the side close to the magazine 8, the pressing portions 926 can pass through the openings 84 and press the support member 82a.

A regulation portion 927 defines the position of the magazine 8 placed on the placement portion 91. In this embodiment, a range defined by a plurality of regulation portions 927 provided on the placement portion 91 is defined as a placement position 91a (alternate long and two short dashed line). In a state in which the magazine 8 is placed at the placement position 91a of the placement portion 91, the pressurization mechanism 92 presses the battery cells 7 stored in the magazine 8. Hence, the relative position of the magazine 8 with respect to the pressurization mechanism 92 is defined by the regulation portions 927. Also, at the time of extraction of the magazine 8, the pressurization state by the pressurization mechanism 92 is canceled, and the regulation portions 927 define the magazine 8 at an extractable position at which the magazine 8 is set in the range of the placement position 91a by the transfer portion 34. The regulation portions 927 include the widthwise direction defining portions 9271 and the extraction position defining portion 9273 (see Fig. 7A and the like). In addition, the regulation portions 927 include a pressurization position defining portion 9272.

A plurality of widthwise direction defining portions 9271 are provided at an interval in a direction crossing the array direction of the battery cells 7 to define the position of the magazine 8 in the widthwise direction horizontal to the placement portion 91. In this embodiment, the widthwise direction defining portion 9271 is a member that is provided while projecting upward from the bottom wall 903 and has a parallelepiped shape with a regulation portion. When the side portions of the magazine 8 abut against the regulation portions of these members, the position of the magazine 8 is defined. In this embodiment, the plurality of widthwise direction defining portions 9271 each having a parallelepiped shape are provided on the bottom wall 903 at an interval in the widthwise direction.

The pressurization position defining portion 9272 defines the arraydirection position of the magazine 8 on the placement portion 91 when the magazine 8 is pressurized by the pressurization mechanism 92. In this embodiment, the pressurization position defining portion 9272 is provided to project from the rear wall 902 to the side of the pressurization mechanism 92. The magazine 8 placed on the placement portion 91 is moved to one side in the array direction by the pressurization operation of the pressurization mechanism 92. When the pressurization position defining portion 9272 abuts against the rear wall 802 of the magazine 8, the pressurization position of the magazine 8 on the placement portion 91 is defined.

The extraction position defining portion 9273 defines an extraction position at the position of the magazine 8 in the array direction when the magazine 8 is extracted from the placement portion 91. In this embodiment, the extraction position defining portion 9273 is a member provided to project from the bottom wall 903 and having a parallelepiped shape with a regulation portion. When the front wall 801 of the magazine 8 abuts against the regulation portion of this member, the extraction position of the magazine 8 on the placement portion 91 is defined.

### <Placement Position of Magazine>

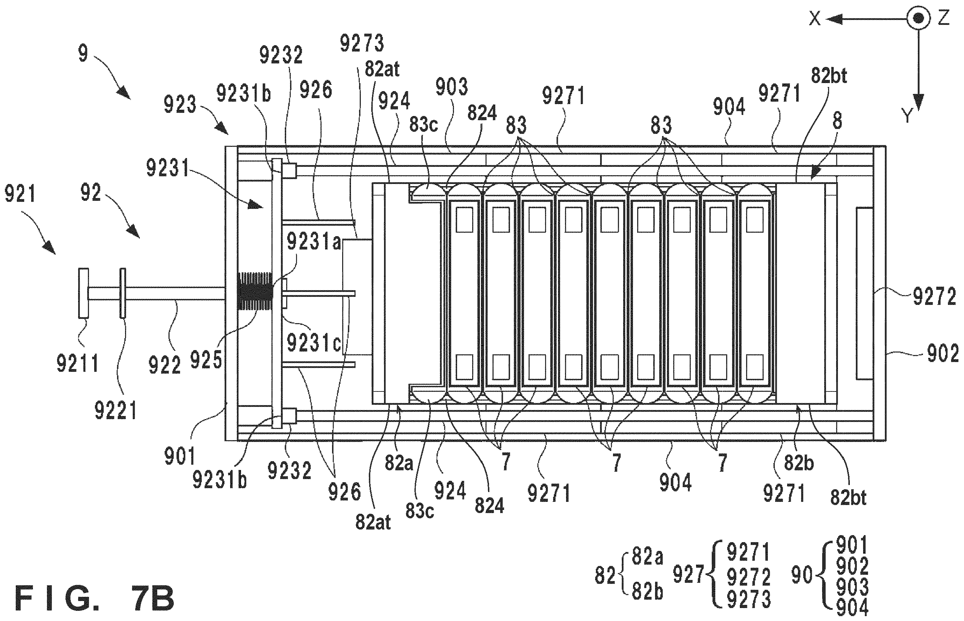

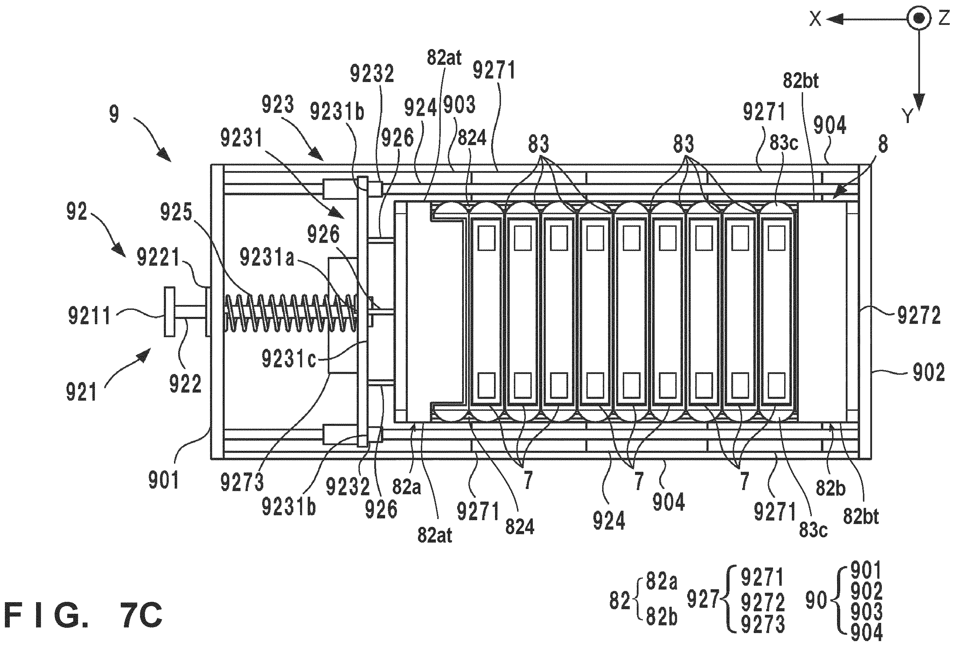

Figs. 7A to 7C are plan views showing states of the test tray 9. Fig. 7A is a view showing a state of the test tray 9 before the magazine 8 is placed in the test tray 9. Fig. 7B is a view showing a state in which the magazine 8 is placed in the test tray 9, and pressurization of the battery cells 7 by the pressurization mechanism 92 is canceled. Fig. 7C is a view showing a state in which the magazine 8 is placed in the test tray 9, and the battery cells 7 are pressurized by the pressurization mechanism 92.

In the state shown in Fig. 7A, the operation unit 332 (see Fig. 4A) operates the operation portion 921 to pull the moving body 923 to the side of the front wall 901, thereby contracting the application member 925 that is a compression spring and arranging the pressing portions 926 outside the range of the placement position 91a. This allows the transfer portion 34 to transfer the magazine 8 in the range of the placement position 91a of the placement portion 91 without making the magazine 8 interfere with the moving body 923.

In the state shown in Fig. 7B, the position of the magazine 8 is arranged in the range of the placement position 91a. When the transfer portion 34 transfers the magazine 8 or extracts the placed magazine 8, the magazine 8 is held by engaging the holding members 3411 with the front wall 801 and the rear wall 802 of the magazine 8. When placing the magazine 8 on the placement portion 91, the magazine 8 is placed in the range of the placement position 91a, and the engagement between the holding members 3411 and the front wall 801 and the rear wall 802 of the magazine 8 is canceled, thereby placing the magazine 8 on the placement 91. When extracting the magazine 8 from the test tray 9, the position of the magazine 8 is moved into the range of the placement position 91a defined by the extraction position defining portion 9273, thereby canceling the abutting state between the rear wall 802 and the pressurization position defining portion 9272 and moving the magazine 8 upward.

In the state shown in Fig. 7C, the magazine 8 is defined by the pressurization position defining portion 9272. The magazine 8 is moved to the side of the rear wall 902 by the pressing portions 926 to which a force is applied by the application member 925, and pressed as the pressurization position defining portion 9272 regulates the movement of the magazine 8. Thus, a pressure is applied, via the support member 82a, to the battery cells 7 stored in the magazine 8. That is, the battery cells 7 are set in a pressurization state. Note that in this embodiment, as the application member 925 that is a compression spring, a member whose natural length is longer than that in the state shown in Fig. 7C is used. More specifically, as the application member 925 that is a compression spring, a member whose natural length is longer than the length of the pressing portions 926 is used. Thus, a pressure is applied to the battery cells 7 by the elastic force of the application member 925.

Also, the pressurization position defining portion 9272 defines the position of the magazine 8 relative to the test tray 9 in the pressurization state. Hence, if the test tray 9 is transferred to the test portion 11, and the test tray 9 is positioned to the test portion 11, the position of the magazine 8 to the test portion 11 is defined. This makes it possible to easily position the magazine 8 when the test tray 9 is transferred to the test portion 11. Hence, the position of a contact element of a test unit provided in the test portion 11 can be matched with the position of the electrode of each battery cell 7 stored in the magazine 8 placed in the test tray 9.

### <Outline of Manufacturing Step of Battery Cell>

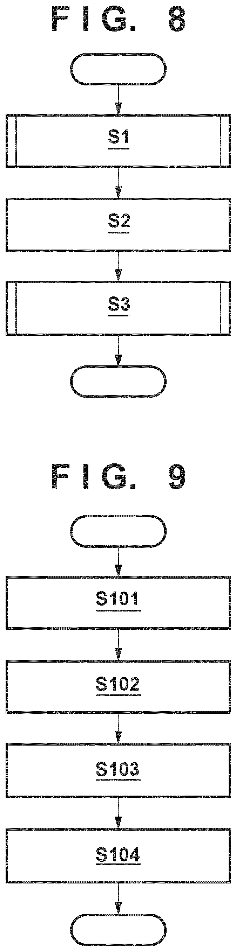

In the manufacturing step of the battery cell 7, after the battery cell 7 is formed, the test of the battery cell 7 is conducted. Fig. 8 is a flowchart showing the outline of a part of the manufacturing step of the battery cell 7. In this embodiment, the manufacturing step of the battery cell 7 includes a battery cell formation step (step S1), a battery cell storage step (step S2), and a battery cell test step (step S3). In the battery cell formation step, the battery cell 7 is formed. In the battery cell storage step, the battery cell 7 formed in the battery cell formation step is stored in the magazine 8. In the battery cell test step, the battery cell 7 stored in the magazine 8 in the battery cell storage step is tested. Thus, in this embodiment, before the test of the battery cell 7 is performed by the above-described test system SY, formation of the battery cell 7 and storage of the formed battery cell 7 in the magazine 8 are performed.

Fig. 9 is a flowchart showing a detailed example of the battery cell formation step (step S1) in Fig. 8.

In an electrode stacking step S101, positive electrodes, negative electrode, and separators are sequentially stacked, thereby forming an electrode stacked body. For example, as the positive electrode, a positive electrode active material may be applied as a slurry containing a binder to both surfaces of an aluminum foil serving as a collector, dried, and rolled to form an active material layer having a predetermined thickness. The collector end portions of a plurality of stacked positive electrodes are overlaid on each other, and positive electrode tabs serving as terminals can be ultrasonically welded. Also, for example, as the negative electrode, a negative electrode active material may be applied as a slurry containing a binder to both surfaces of a copper foil serving as a collector, dried, and rolled to form an active material layer having a predetermined thickness. The collector end portions of a plurality of stacked negative electrodes are overlaid on each other, and negative electrode tabs serving as terminals can be ultrasonically welded. Also, for example, the separator may have a function of preventing a short circuit between the positive electrode and the negative electrode and simultaneously holding an electrolyte, and can be formed by a microporous film of a synthetic resin such as polyethylene (PE) or polypropylene (PP) or a nonwoven fabric.

In a wrapping step S102, the electrode stacked body formed in step S101 is arranged in a flexible film-shaped exterior body. The exterior body can be formed by a laminate film having a three-layered structure obtained by, for example, laminating a thermally fused layer of a synthetic resin on the inner surface of an aluminum foil and laminating a protective layer of a synthetic resin on the outer surface. As an example, the exterior body is formed by one laminate film arranged on the lower surface side of the electrode stacked body and another laminate film arranged on the upper surface side. The electrode stacked body may be arranged between the two laminate films, and three sides of four peripheral sides except one side left as an injection port may be overlaid and thermally fused to each other.

In a liquid injection step S103, an electrolyte is injected from the injection port of the exterior body. For example, the liquid injection is performed a plurality of times in a predetermined decompression state. This makes it possible to inject the electrolyte while removing air remaining inside the exterior body.

In a sealing step S104, the injection port is sealed by thermal fusion or the like. In an embodiment, sealing here is so-called temporary sealing. After charge/discharge to be described later, the injection port or a portion near that is opened to remove a gas generated in charge. Hence, final sealing is performed after the gas removal. By the above-described steps, the battery cell 7 is formed.

### <Example of Control of Test System>

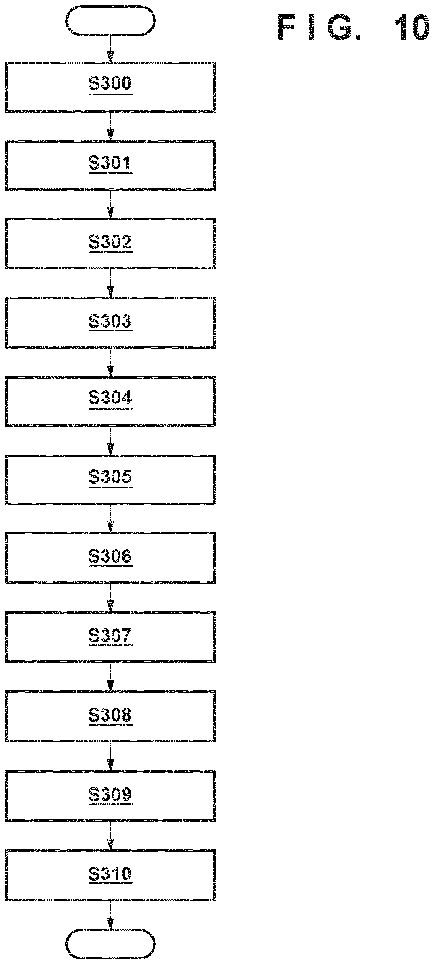

An example of control of the test system SY will be described. Fig. 10 is a flowchart showing an example of control of the test system SY, and shows a detailed example of step S3 in Fig. 8. For example, this flowchart is implemented by the CPU of the host computer 5 or the CPUs of the control devices 10, 20, and 30 reading out programs stored in the ROMs or the like to the RAMs and executing the programs and the control devices 10, 20, and 30 thus controlling the operations of the constituent elements included in their control ranges of the test system SY Also, for example, the operations of the constituent elements of the test system SY in this flowchart are executed for the magazine 8 in which the battery cells 7 to be tested in the test area 1 are stored.

Step S300 is a first magazine transfer step of transferring the magazine 8 into the range of the test system SY The magazine 8 that stores the battery cells 7 outside the range of the test system SY, that is, the magazine 8 storing the untested battery cells 7 is transferred into the range of the test system SY In this embodiment, the magazine 8 storing the untested battery cells 7 is transferred to the carry-in conveyor 311 of the magazine conveyance portion 31 by a transfer device or the like (not shown).

Step S301 is a second magazine transfer step. The carry-in conveyor 311 conveys the magazine 8 transferred from the outside of the test system SY into the range of the test system SY to near the work portion 33. For example, the processing portion 51 of the host computer 5 issues a conveyance instruction of the magazine 8 to the preparation control device 30, and the preparation control device 30 that has received the instruction controls the magazine conveyance portion 31 to make it to convey the magazine 8.

Step S302 is a magazine placement step. The transfer portion 34 holds the magazine 8 standing by in the magazine extraction portion set on the carry-in conveyor 311, extracts the magazine 8 from the magazine extraction portion, transfers the magazine 8 to the test tray 9 standing by in the work area 330 in advance, and places the magazine 8 in it. The magazine placement step includes a test tray positioning step of supporting the test tray 9 in the work area 330 and positioning the test tray 9 by operating the regulation unit 333. The magazine placement step also includes a magazine placement preparation step of operating the operation unit 332 to operate the pressurization mechanism 92 of the test tray 9 positioned in the work area 330, canceling the pressurization state of the pressurization mechanism 92, and enabling placement of the magazine 8 on the placement portion 91 of the test tray 9. The magazine placement step also includes a magazine placement completion step of placing the magazine 8 on the placement portion 91 of the test tray 9 and causing the transfer portion 34 to cancel holding of the magazine 8.

Step S303 is a pressurization step. The operation unit 332 operates, and the pressurization mechanism 92 thus presses the battery cells 7 stored in the magazine 8 placed in the test tray 9 to one side in the array direction and holds the battery cells 7 in the test tray 9 together with the magazine 8. The pressurization step includes a pressurization moving step of operating the operation unit 332 to operate the pressurization mechanism 92 and pressing the battery cells 7 stored in the magazine 8 placed in the test tray 9 to one side in the array direction to move the magazine 8 to a predetermined position with respect to the test tray 9 and also move each battery cell 7 to a predetermined position with respect to the magazine 8, and a pressurization holding step of positioning each battery cell 7 moved in the array direction at a predetermined position of the magazine 8 in the array direction and also position the magazine 8 placed in the test tray 9 to a predetermined position of the test tray 9 in the array direction and hold the magazine 8.

Step S304 is a test management step. The processing portion 51 acquires information about the test state of each test portion 11 in the test area 1. For example, the processing portion 51 acquires availability state information of each test portion 11 or test time state information such as an estimated test completion time from the test portion control device 10. The test management step includes a test information collection step of collecting the information of the test state of each test portion 11.

Step S305 is a test decision step. Based on the information of the test state acquired in the test management step, the processing portion 51 decides the test portion 11 as the conveyance destination of the test tray 9 in which the magazine 8 is placed. The test decision step includes a test information comparison step of comparing the pieces of test information of the test portions 11, and a transfer destination extraction step of extracting the test portion 11 as the transfer destination of the test tray 9 based on the compared pieces of test information. This makes it possible to effectively transfer the test tray 9 in accordance with the states of the plurality of test portions 11. Note that the processing portion 51 may acquire and manage information about the test state of each test portion 11 independently of the processing to be described with reference to the flowchart. In this case, the processing portion 51 may omit the processing of the test management step and decide the test portion 11 as the conveyance destination based on the information under management. Note that the processing portion 51 may periodically acquire the information of the test portion 11. In addition, a test information updating step may be included such that if the state of the test portion 11 is updated, the updated information is transmitted from the test portion control device 10 to the processing portion 51 every time.

Step S306 is a first test tray transfer step, and the test tray 9 is transferred from the preparation area 3 to the test area 1. The first test tray transfer step includes a test tray carry-out step of operating the lifting unit 331 to move the test tray 9 in the work area 330 to the test tray conveyance portion 32 on the lower side, and causing the test tray conveyance portion 32 to convey the test tray 9 moved to the conveyance portion 32 to the carry-out portion 36. The first test tray transfer step also includes a test portion transfer step of operating the lifting unit 361 to raise the test tray 9 from the conveyance portion 32 such that the test tray transferred to the carry-out portion 36 can be collected by the fork of the transfer portion 2 or the like, and then causing the transfer portion 2 to transfer the test tray 9 to the test portion 11 decided in the test decision step. In this embodiment, since a preparation is made in the pressurization step to set a state in which the battery cells 7 are pressed to one side in the array direction in advance and positioned at a predetermined position, the test tray 9 is transferred to the test portion 11 in the pressurization state in which the position of the magazine 8 with respect to the test tray 9 and the positions of the battery cells 7 with respect to the magazine 8 are defined and held.

Step S307 is a charge/discharge test execution step, and a test associated with charge/discharge of the battery cell 7 is executed based on a preset test process. The test process includes steps of initial charge, aging, and discharge.

Step S308 is a second test tray transfer step, and the test tray 9 is transferred from the test area 1 to the preparation area 3 based on the processing of the test management step. The second test tray transfer step includes a test tray carry-in step of causing the transfer portion 2 to transfer the test tray 9 to the carry-in portion 35 in the preparation area 3 and place the test tray 9 on the lifting unit 351 above the carry-in portion 35 and operating the lifting unit 351 to move the test tray 9 to the lower side and place the test tray 9 on the test tray conveyance portion 32. The second test tray transfer step also includes a work portion transfer step of causing the test tray conveyance portion 32 to move the test tray 9 placed on the test tray conveyance portion 32 to the work portion 33 and operating the lifting unit 331 to move the test tray 9 transferred to the work portion 33 to the work area 330 on the upper side.

Step S309 is a pressurization cancel step, and the pressurization state of the battery cells 7 pressurized by the pressurization mechanism 92 of the test tray 9 is canceled. The test tray 9 transferred to the carry-in portion 35 is conveyed to near the work portion 33 by the test tray conveyance portion 32. After that, the test tray 9 is transferred to the work area 330 of the work portion 33 by the transfer portion 34. The operation unit 332 operates the operation portion 921 of the test tray 9 transferred to the work area 330, thereby canceling the pressurization state of the battery cells 7.

Step S310 is a magazine extraction step. The transfer portion 34 extracts, from the test tray 9, the magazine 8 placed on the placement portion 91 of the test tray 9. The transfer portion 34 transfers the extracted magazine 8 to the carry-out conveyor 312. The magazine 8 is conveyed to the carry-out position by the carry-out conveyor 312. The magazine 8 at the carry-out position, in which the tested battery cells 7 are stored, is carried by a conveyance device or the like (not shown) to a place where a downstream step is performed. In this embodiment, for example, the magazine 8 is transferred to the sealing step again, and final sealing is performed.

Note that in the test tray 9 after the magazine 8 is extracted, the subsequent magazine 8 conveyed to the work portion 33 by the carry-in conveyor 311 is placed. In this way, the magazine 8 placed in the test tray 9 is changed in the work portion 33.

As described above, in this embodiment, the test tray 9 including the pressurization mechanism 92 is used only in the test area where the test is performed. In the steps before and after the test step, the battery cells 7 are conveyed using the magazine 8 that does not include a pressurization mechanism. Hence, the configuration of the magazine 8 can be simplified as compared to the magazine 8 with a pressurization mechanism. This can reduce the cost of the magazine 8 by decreasing the number of parts. Also, in this embodiment, since the battery cells 7 are transferred by the magazine 8 in the steps before and after the test, the necessary number of test trays 9 can be decreased, and the manufacturing cost in the entire manufacturing facility can be reduced.

Also, in this embodiment, in the preparation area 3, the plurality of battery cells 7 stored in the magazine 8 are positioned to one side in the array direction and set in the pressurization state, and after that, the test tray 9 is conveyed to the test portion 11. Hence, for example, as compared to a case where the pressurization mechanism of the battery cells 7 is not provided in the magazine 8, and the mechanism for pressing is provided in the test portion 11, lowering of the test efficiency can be suppressed. That is, if the mechanism for pressing the battery cells 7 is provided in the test portion 11, the pressurization operation of the battery cells 7 and the pressurization state cancel operation need to be performed in the test portion 11. Hence, in the test method according to this embodiment, since the time per occupation of the test portion 11 by the test tray 9 can be shortened, it is possible to suppress lowering of the test efficiency in the entire test system SY including the plurality of test portions 11.

### <Second Embodiment>

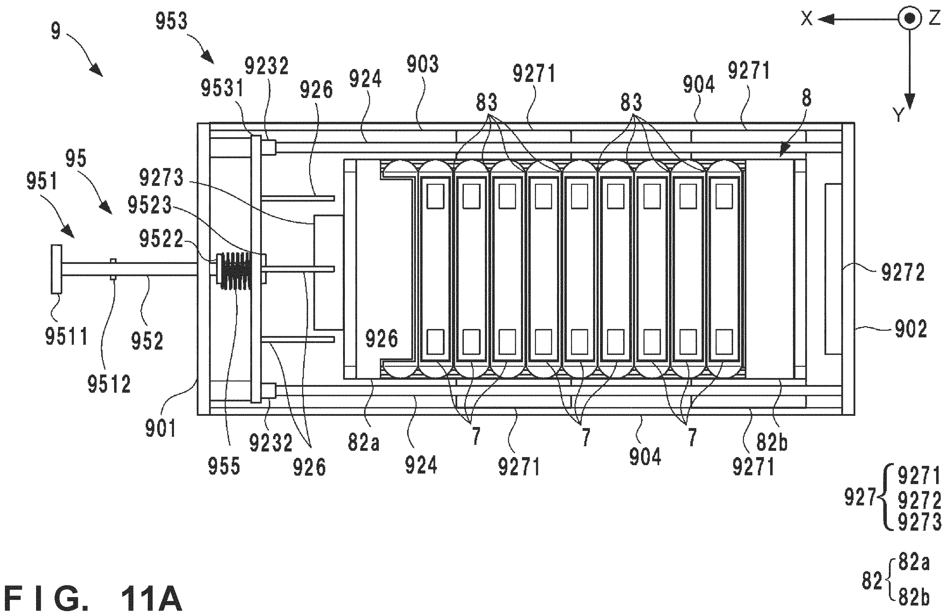

In the second embodiment, the structure of a pressurization mechanism is different from the first embodiment in that, for example, a pressurization mechanism includes a pressurization movement regulation portion. The second embodiment will be described below with reference to Figs. 11A to 12B. A description of the same components as in the first embodiment will sometimes be omitted.

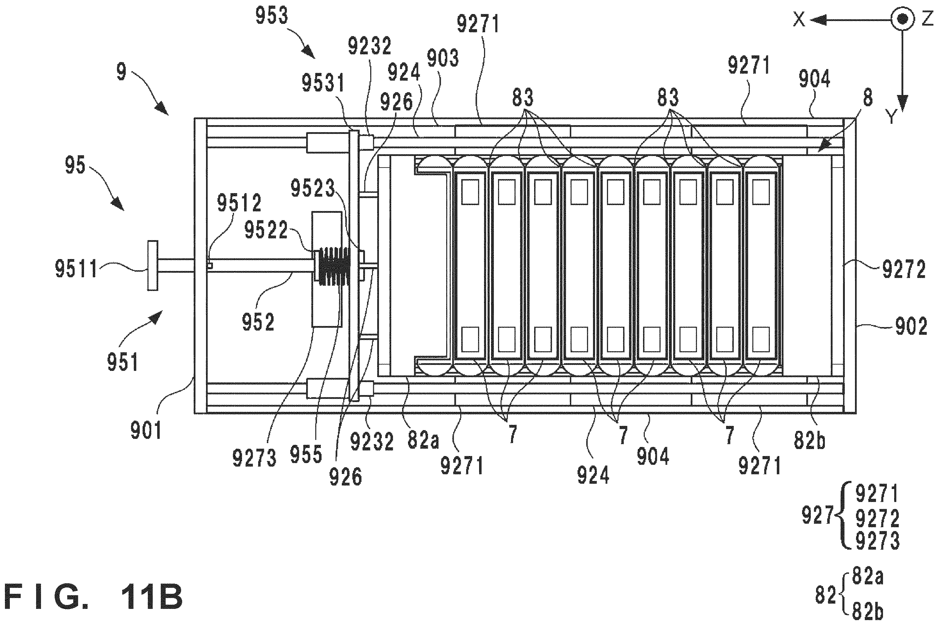

Figs. 11A and 11B are plan views for explaining the configuration of a test tray 9 according to the second embodiment. Fig. 11A shows a state in which battery cells 7 stored in a magazine 8 are not pressurized, and Fig. 11B shows a state in which the battery cells 7 stored in the magazine 8 are pressurized.

A pressurization mechanism 95 includes an operation portion 951, a transmission member 952, a moving body 953, guide members 924, an application member 955, and pressing portions 926. The operation portion 951 of the pressurization mechanism 95 includes an operation member 9511, and a pressurization movement regulation portion 9512. The operation member 9511 is a rectangular flange member that is provided at one end portion of the transmission member 952 and extends from the transmission member 952 in a direction crossing the array direction. The pressurization movement regulation portion 9512 regulates the movement of the moving body 953 that is moved in a direction reverse to a direction of applying a force by the application member 955 (the direction of separating the operation member 9511 from a plate-shaped member 9531 based on the plate-shaped member 9531 as a reference: the positive direction of the X direction). In this embodiment, the pressurization movement regulation portion 9512 is a convex member that projects in a direction crossing the moving direction of the transmission member 952 and is provided between the operation member 9511 and the plate-shaped member 9531.

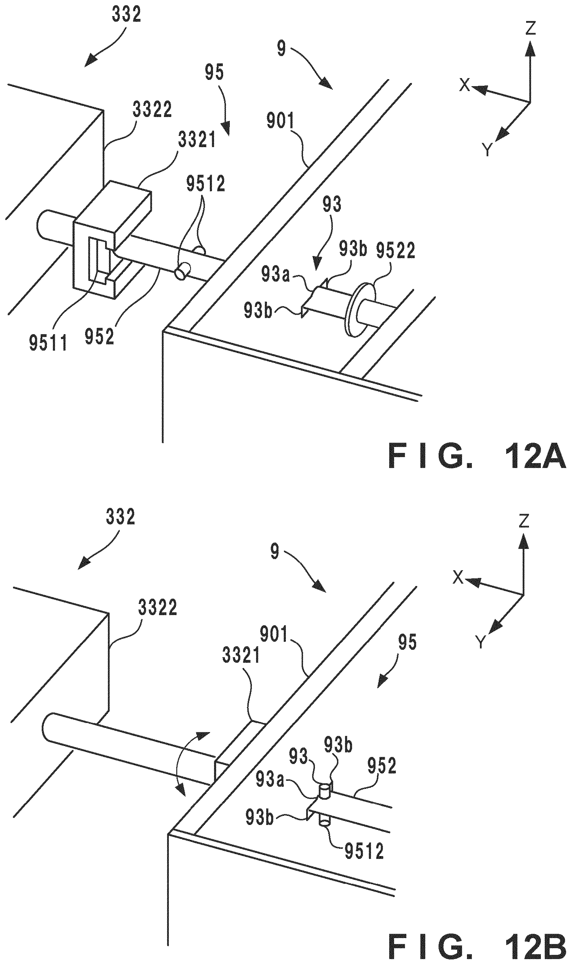

Also, in this embodiment, the application member 955 is provided between a flange portion 9522 provided on the transmission member 952 and the plate-shaped member 9531 of the moving body 953. In addition, the plate-shaped member 9531 of the moving body 953 is provided to be slidable between the flange portion 9522 and a flange portion 9523. In a state shown in Fig 12A, the moving body 953 is pressed by the elastic force of the application member 955 to the side of the flange portion 9523 based on the flange portion 9522 as a reference and in this state, formed on the transmission member 952.

Fig. 12A is a view for explaining a regulation operation by the pressurization movement regulation portion 9512, and is a view showing a state before regulation. Fig. 12B is a view for explaining a regulation operation by the pressurization movement regulation portion 9512, and is a view showing a state at the time of regulation.

In this embodiment, the transmission member 952 is a rod-shaped member that connects the operation member 9511 and the plate-shaped member 9531 of the moving body 953. The transmission member 952 is provided through an opening 93 formed in a front wall 901 and provided to be movable relative to the front wall 901. Also, the transmission member 952 is provided through an opening (not shown) formed in the plate-shaped member 9531. The circular flange portion 9523 extending from the transmission member 952 in a direction crossing the array direction is provided at the other end portion of the transmission member 952, and the transmission member 952 and the plate-shaped member 9531 are configured to be relatively movable. The transmission member 952 can be moved in the axial direction by the operation of the operation portion 951 by an operation unit 332, and is also provided to be rotatable about the axis of the transmission member 952 extended in the array direction with respect to the moving body 953.

Also, the opening 93 includes a center opening 93a that receives the transmission member 952, and key openings 93b having a key shape capable of passing the pressurization movement regulation portion 9512 when the transmission member 952 is moved to a predetermined rotation angle about the axis of the transmission member 952. In the example shown in Fig. 12A, as the key openings 93b of the opening 93, openings with a long shape extending from the center opening 93a in the horizontal direction (Y direction) parallel to the placement surface of a placement portion 91 are formed. Hence, by making the pressurization movement regulation portion 9512 projecting from the transmission member 952 in the circumferential direction match the key openings 93b, the pressurization movement regulation portion 9512 can be passed through the opening 93.

On the other hand, after the pressurization movement regulation portion 9512 is passed through the opening 93 from one side of the front wall 901 (from the state shown in Fig. 12A) to the other side of the front wall 901, the transmission member 952 is rotated (rotated by 90° in the example shown in Fig. 12B). This makes the phases of the pressurization movement regulation portion 9512 and the key openings 93b mismatch, and the movement of the moving body 923 from the other side to the one side in the array direction is regulated by the front wall 901. This also regulates the movement of the moving body 953 provided while being connected to the transmission member 952.

If a test of charge/discharge or the like is executed in a state in which the battery cells 7 are pressurized, the battery cells 7 may expand. If the battery cells 7 expand, a force in the positive direction of the X direction (to the side of the front wall 901 based on a rear wall 902 as a reference) is applied to the moving body 953. In this embodiment, the movement of the moving body 953 caused by the expansion of the battery cells 7 can be suppressed in a predetermined moving range by the pressurization movement regulation portion 9512.

### <Third Embodiment>

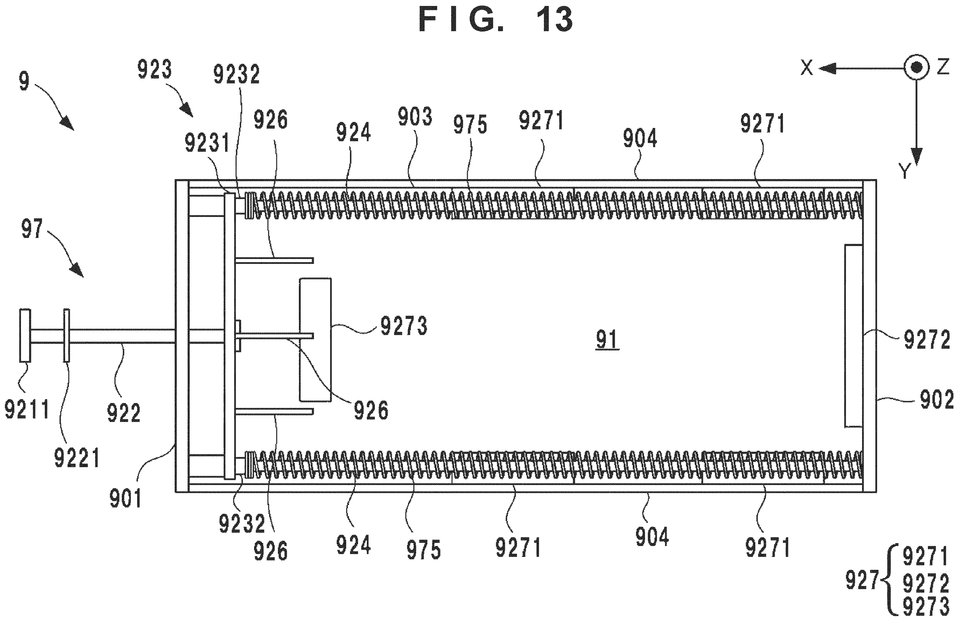

In the third embodiment, the configuration of an application member is different from the first and second embodiments. The third embodiment will be described below with reference to Fig. 13. A description of the same components as in the first and second embodiments will sometimes be omitted.

Fig. 13 is a plan view for explaining the configuration of a test tray 9 according to the third embodiment. The application member according to each of the first and second embodiments is a compression spring that is provided between the front wall 901 and the moving body 923 and applies a repelling force. However, an application member 975 according to this embodiment is a tension spring that applies a contraction force.

The application member 975 of a pressurization mechanism 97 is provided to surround the periphery of a guide member 924. One end of the application member 975 is attached to a sliding body 9232 of a moving body 923, and the other end portion is attached to a rear wall 902. By the force of contracting the application member 975 that is a tension spring, the moving body 923 is pulled to the side of the rear wall 902 (the negative direction of the X direction). By the contraction force, battery cells 7 stored in a magazine 8 can be pressed by pressing portions 926.

The invention is not limited to the foregoing embodiments, and various variations/changes are possible within the spirit of the invention.

### REFERENCE SIGNS LIST

1: test area, 2: transfer portion, 3: preparation area, 7: battery cell, 8: magazine, 9: test tray, SY: test system

## Claims

1. A test method of a battery cell, comprising:
a placement step of a device placing, in a test tray, a magazine in which a plurality of battery cells are arrayed and stored, the test tray including a pressurization mechanism configured to press, in an array direction, the plurality of battery cells stored in the magazine;
a pressurization step of pressing the plurality of battery cells stored in the magazine in the array direction by the pressurization mechanism;
a transfer step of transferring the test tray storing the magazine between a preparation area where the magazine is placed in the test tray in the placement step and a test area where a test of the plurality of battery cells is performed; and
a test step of performing, in the test area, a test concerning charge/discharge of the plurality of battery cells in a state in which the plurality of battery cells are pressurized by the pressurization mechanism.

2. The test method according to claim 1, further comprising a cancel step of canceling the pressurization state of the plurality of battery cells pressurized by the pressurization mechanism.

3. The test method according to claim 1 or 2, further comprising:
a test management step of managing information about a test state of each of a plurality of test portions provided in the test area; and
a decision step of deciding the test portion serving as a transfer destination of the test tray based on the test state managed in the test management step.

4. The test method according to any one of claims 1 to 3, wherein the transfer step includes:
a first transfer step of transferring, from the preparation area to the test area, the test tray in which the plurality of battery cells before the test, which are pressurized by the pressurization mechanism, are placed; and
a second transfer step of transferring, from the test area to the preparation area, the test tray in which the plurality of battery cells after the test are placed.

5. The test method according to any one of claims 1 to 4, further comprising an extraction step of extracting the magazine from the test tray after an end of the test in the test step.

6. The test method according to any one of claims 1 to 5, further comprising a third transfer step of transferring, to the preparation area, the magazine in which the plurality of battery cells are arrayed and stored.

7. A manufacturing method of a battery cell, comprising:
a formation step of forming a battery cell;
a placement step of a device placing, in a test tray, a magazine in which a plurality of battery cells formed in the formation step are arrayed and stored, the test tray including a pressurization mechanism configured to press, in an array direction, the plurality of battery cells stored in the magazine;
a pressurization step of pressing the plurality of battery cells stored in the magazine in the array direction by the pressurization mechanism;
a transfer step of transferring the test tray storing the magazine between a preparation area where the magazine is placed in the test tray in the placement step and a test area where a test of the plurality of battery cells is performed; and
a test step of performing, in the test area, a test concerning charge/discharge of the plurality of battery cells in a state in which the plurality of battery cells are pressurized by the pressurization mechanism.

8. The manufacturing method according to claim 7, further comprising a cancel step of canceling the pressurization state of the plurality of battery cells pressurized by the pressurization mechanism.

9. The manufacturing method according to claim 7 or 8, further comprising:
a test management step of managing information about a test state of each of a plurality of test portions provided in the test area; and
a decision step of deciding the test portion serving as a transfer destination of the test tray based on the test state managed in the test management step.

10. The manufacturing method according to any one of claims 7 to 9, wherein the transfer step includes:
a first transfer step of transferring, from the preparation area to the test area, the test tray in which the plurality of battery cells before the test, which are pressurized by the pressurization mechanism, are placed; and
a second transfer step of transferring, from the test area to the preparation area, the test tray in which the plurality of battery cells after the test are placed.

11. The manufacturing method according to any one of claims 7 to 10, further comprising an extraction step of extracting the magazine from the test tray after an end of the test in the test step.

12. The manufacturing method according to any one of claims 7 to 11, further comprising a third transfer step of transferring, to the preparation area, the magazine in which the plurality of battery cells formed in the formation step are arrayed and stored.

13. The manufacturing method according to any one of claims 7 to 12, wherein the formation step includes at least one of:
a stacking step of stacking a plurality of positive electrodes and negative electrodes while interposing separators therebetween to form an electrode stacked body;
a wrapping step of storing, in an exterior member, the electrode stacked body formed in the stacking step;
a liquid injection step of injecting an electrolyte from an injection port of the exterior member; and
a sealing step of sealing the exterior member to which the electrolyte is injected in the liquid injection step.
